# EUROPEAN PATENT APPLICATION

(11) **EP 4 355 036 A1**
(43) Date of publication of application: **17.04.2024**
(21) Application number: 23198243.0
(22) Date of filing: 19.09.2023
(51) Int. Cl.: H05K 1/02, H05K 1/11, H05K 1/14

(54) **CONDUCTIVE FILM AND TEST COMPONENT**

(30) Priority: 12.10.2022 US 202263415283 P; 14.07.2023 CN 202310867288
(71) Applicant: InnoLux Corporation, Jhunan Town Miao li 35053 (TW)
(72) Inventor: KAO, Ker-Yih, 35053 Jhunan Town, Miaoli County (TW); FAN, Kuang-Ming, 35053 Jhunan Town, Miaoli County (TW); YANG, Chia-Lin, 35053 Jhunan Town, Miaoli County (TW); YUEH, Jui-Jen, 35053 Jhunan Town, Miaoli County (TW); WANG, Ju-Li, 35053 Jhunan Town, Miaoli County (TW)
(74) Representative: Becker, Eberhard

(57) **Abstract**

Disclosed are a conductive film (100) and a test component (10). A conductive film (100) includes a supporting layer (110), a circuit layer (CL) and a protective layer (150). The supporting layer (110) has a first surface (111) and a second surface (112) opposite to the first surface (111). The supporting layer (110) supports the circuit layer (CL). The circuit layer (CL) includes a first protruding part (120), a second protruding part (130) and a connecting part (140). The first protruding part (120) is disposed on the first surface (111). The second protruding part (130) is disposed on the second surface (112). The connecting part (140) is disposed between the first protruding part (120) and the second protruding part (130). The first protruding part (120) is connected to the second protruding part (130) through the connecting part (140). The protective layer (150) covers the first protruding part (120). The conductive film (100) and the test component (10) of the disclosed embodiments may have a buffering effect or increase the service life.

## Description

### BACKGROUND

### Field of the Disclosure

The disclosure relates to a conductive film and a test component, in particular to a conductive film and a test component that may have a buffering effect or increase the service life.

### Description of Related Art

Electronic devices or spliced electronic devices are widely adopted in different fields such as communication, display, vehicle or aviation. With the vigorous development of electronic devices, electronic devices have been developed to be thin and light, and therefore the requirements set for reliability or quality of electronic devices are higher than before.

### SUMMARY OF THE DISCLOSURE

The present disclosure provides a conductive film and a test component, which may have a buffering effect or increase the service life.

In an embodiment of the present disclosure, a conductive film includes a supporting layer, a circuit layer and a protective layer. The supporting layer has a first surface and a second surface opposite to the first surface. The supporting layer supports the circuit layer. The circuit layer includes a first protruding part, a second protruding part and a connecting part. The first protruding part is disposed on the first surface. The second protruding part is disposed on the second surface. The connecting part is disposed between the first protruding part and the second protruding part. The first protruding part is connected to the second protruding part through the connecting part. The protective layer covers the first protruding part.

In an embodiment of the present disclosure, a test component includes a circuit board, a bonding pad, and a conductive film. The conductive film is electrically connected to the circuit board through the bonding pad. The conductive film includes a supporting layer, a circuit layer and a protective layer. The supporting layer has a first surface and a second surface opposite to the first surface. The supporting layer supports a circuit layer. The circuit layer includes a first protruding part, a second protruding part and a connecting part. The first protruding part is disposed on the first surface. The second protruding part is disposed on the second surface. The connecting part is disposed between the first protruding part and the second protruding part. The first protruding part is connected to the second protruding part through the connecting part. The protective layer covers the first protruding part.

### BRIEF DESCRIPTION OF THE DRAWINGS

The accompanying drawings are included to provide a further understanding of the disclosure, and are incorporated in and constitute a part of this specification. The drawings illustrate of the disclosure and, together with the description, serve to explain the principles of the disclosure.
FIG. 1A to FIG. 1C are schematic cross-sectional views of a manufacturing method of a test component according to an embodiment of the present disclosure.
FIG. 2 to FIG. 7 are schematic cross-sectional views of test components of various embodiments of the present disclosure.
FIG. 8A is a schematic top view of a test component according to another embodiment of the present disclosure.
FIG. 8B is a schematic cross-sectional view of the test component of FIG. 8A taken along the section line I-I'.
FIG. 9A to FIG. 9B are schematic cross-sectional views of a manufacturing method of a test component according to another embodiment of the present disclosure.
FIG. 10 to FIG. 12 are schematic cross-sectional views of test components according to various embodiments of the present disclosure.

### DESCRIPTION OF EMBODIMENTS

The present disclosure may be understood by referring to the following detailed description in combination with the accompanying drawings. It should be noted that, for ease of understanding and the brevity of the drawings, several drawings in the present disclosure only show a part of the electronic device, and specific components in the drawings are not drawn according to actual scale. In addition, the number and size of each component in the figure are only for illustration, and are not intended to limit the scope of the present disclosure.

In the following description and claims, terms such as "comprising" and "including" are open-ended words, so they should be interpreted as meaning "including but not limited to...".

It will be understood that when an element or film is referred to as being "on" or "connected to" another element or film, it can be directly on or directly connected to the other element or layer or there may be intervening elements or layers in between (in the case of indirection connection). In contrast, when an element is referred to as being "directly on" or "directly connected to" another element or layer, there are no intervening elements or layers present.

Although the terms "first", "second", "third"... may be used to describe various constituent elements, the constituent elements are not limited to this term. This term is only used to distinguish a single constituent element from other constituent elements in the specification. The same terms may not be used in the claims, but are replaced by first, second, third... in the order in which elements are declared in the claims. Therefore, in the following description, a first constituent element may be a second constituent element in the claims.

In the description, the terms "about", "approximately", "substantially" or "generally" are normally interpreted as being within 10% of a given value or range, or as being within 5%, 3%, 2%, 1%, or 0.5% of a given value or range. The given quantity here is an approximate quantity, that is, the meanings of "about", "approximately", "substantially" and "generally" may still be implied if "about", "approximately", "substantially" and "generally" are not specified.

In some embodiments of the present disclosure, terms such as "connection" and "interconnection" related to bonding and connection, unless otherwise specified, may mean that two structures are in direct contact, or may also mean that two structures are not in direct contact, and there are other structures disposed between the two structures. And the terms about joining and connecting may also include the situation that both structures are movable, or both structures are fixed. In addition, the term "coupled" includes any direct and indirect electrical connection means.

In some embodiments of this disclosure, the area, width, thickness or height of various elements or distance or spacing between elements may be measured by optical microscopy (OM), scanning electron microscope (SEM), film thickness profiler (*α* -step), ellipsometer, or other suitable methods. In detail, according to some embodiments, a scanning electron microscope can be used to obtain a cross-sectional structure image including the elements to be measured, and measure the area, width, thickness or height of each element, or the distance or spacing between elements.

The conductive film and test component of the present disclosure may be applied to electronic devices. The electronic device may include a display device, an antenna device, a sensing device or a splicing device, but is not limited thereto. The electronic device may be a bendable or flexible electronic device. The electronic device may, for example, include liquid crystal light-emitting diodes; the light-emitting diodes may, for example, include organic light-emitting diodes (OLEDs), submillimeter light-emitting diodes (mini LEDs), micro light-emitting diodes (micro LEDs) or quantum dot light-emitting diodes (quantum dots, QDs, such as QLEDs, QDLEDs), fluorescence, phosphor or other suitable materials, and the materials may be arranged in any combination, but the disclosure is not limited thereto. The antenna device may be, for example, a liquid crystal antenna, but is not limited thereto. The splicing device may be, for example, a display splicing device or an antenna splicing device, but is not limited thereto. It should be noted that the electronic device may be any permutation and combination of the aforementioned, but not limited thereto. Hereinafter, the content of the disclosure will be described with the conductive film and the test component, but the disclosure is not limited thereto.

It should be noted that, in the following embodiments, without departing from the spirit of the present disclosure, the features in several different embodiments can be replaced, reorganized, and mixed to complete other embodiments. As long as the features of the various embodiments do not violate the spirit of the disclosure or conflict with each other, they can be mixed and matched freely.

Reference will now be made in detail to the exemplary embodiments of the present disclosure, examples of which are illustrated in the accompanying drawings. Wherever possible, the same reference numbers will be used in the drawings and description to refer to the same or like parts.

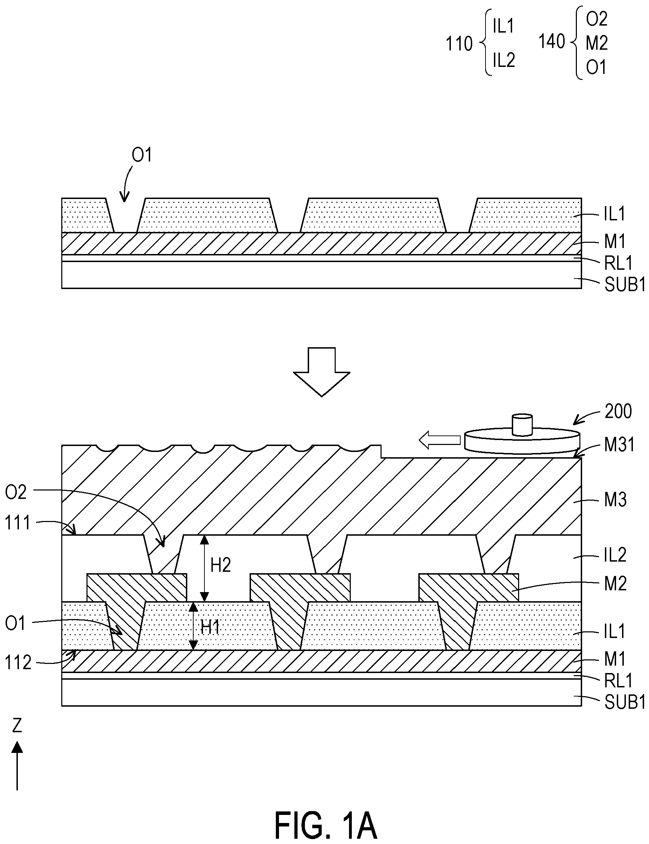

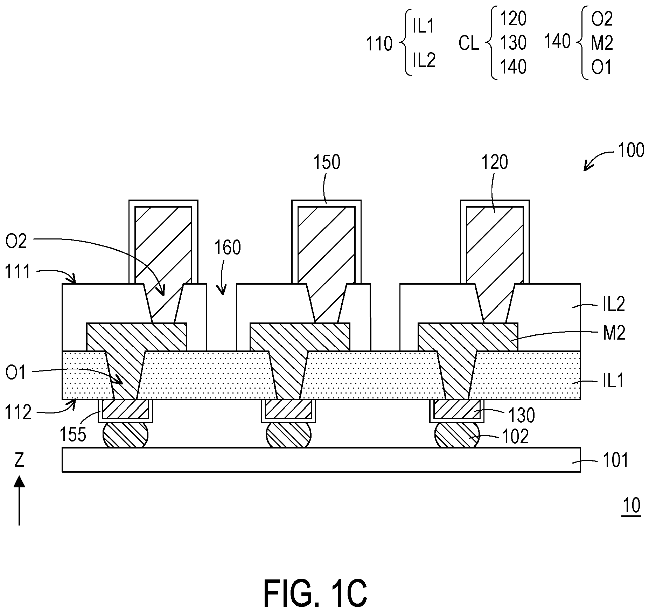

FIG. 1A to FIG. 1C are schematic cross-sectional views of a manufacturing method of a test component according to an embodiment of the present disclosure. Please refer to FIG. 1C first. The test component 10 of this embodiment includes a circuit board 101, a bonding pad 102 and a conductive film 100. The conductive film 100 is electrically connected to the circuit board 101 through the bonding pad 102. The conductive film 100 includes a supporting layer 110, a circuit layer CL and a protective layer 150. The supporting layer 110 has a first surface 111 and a second surface 112 opposite to the first surface 111. The supporting layer 110 supports the circuit layer CL. The circuit layer CL includes a first protruding part 120, a second protruding part 130 and a connecting part 140. The first protruding part 120 is disposed on the first surface 111. The second protruding part 130 is disposed on the second surface 112. The connecting part 140 is disposed between the first protruding part 120 and the second protruding part 130. The first protruding part 120 is connected to the second protruding part 130 through the connecting part 140. The protective layer 150 covers the first protruding part 120. According to some embodiments, the circuit layer CL may be disposed on the first surface 111 or the second surface 112 of the supporting layer 110, but not limited thereto. According to some embodiments, the conductive film 100 may be a conductive film distributed with conductive lines for electrically connecting at least two or more electronic components, such as for electrically connecting a chip and a circuit board, wherein at least two or more electronic components may be disposed on opposite sides of the conductive film 100, or at least two or more electronic components may be disposed on the same side of the conductive film 100, but not limited thereto.

In this embodiment, the test component 10 may be used to conduct open circuit test and/or short circuit test and other circuit tests on the object under test (not shown). The supporting layer 110 may be used to carry or support the circuit layer CL. The first protruding part 120 may be used as a probe head for contacting the object under test. The second protruding part 130 may be used to be bonded to the circuit board 101. The connecting part 140 may be used to electrically connect the first protruding part 120 and the second protruding part 130.

Next, a method of manufacturing the test component 10 of this embodiment will be described. In this embodiment, the manufacturing method of the test component 10 may include the following steps:

First, referring to FIG. 1A to FIG. 1B, a conductive film 100 is formed. In this embodiment, the step of forming the conductive film 100 may include: forming a supporting layer 110, forming a circuit layer CL, and forming a protective layer 150.

Specifically, referring to FIG. 1A, a carrier substrate SUB1 is provided, a release layer RL1 is formed on the carrier substrate SUB1, a first metal layer M1 is formed on the release layer RL1, and a first insulating layer IL1 is formed on the first metal layer M1. In this embodiment, the carrier substrate SUB1 may include a rigid substrate, a flexible substrate, or a combination of the foregoing. For example, the material of the carrier substrate SUB1 may include glass, quartz, sapphire, ceramics, polycarbonate (PC), polyimide (PI), polyethylene terephthalate (PET), epoxy, other suitable substrate materials or the aforementioned combination, but not limited thereto. When the carrier substrate SUB1 is a rigid substrate (such as glass), the surface of the first metal layer M1 formed on the carrier substrate SUB1 may be made flat without unevenness, so as to improve the effect of subsequent electrical testing.

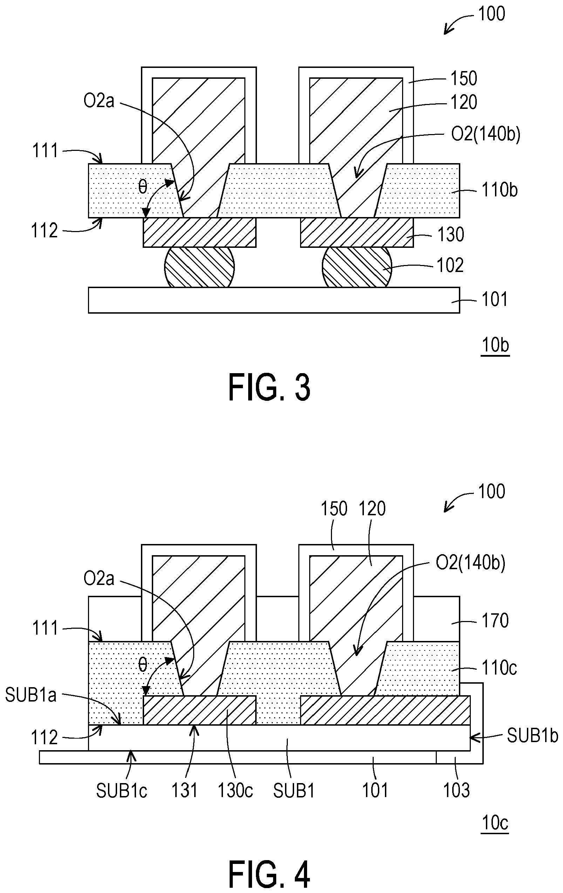

In this embodiment, the release layer RL1 is disposed between the first metal layer M1 and the carrier substrate SUB 1, and the release layer RL1 may be removed together with the carrier substrate SUB1 in subsequent steps. The material of the release layer RL1 may include an adhesive material that loses its adhesive property when heated or irradiated by ultraviolet light, but is not limited thereto. In some embodiments, no additional release layer may be provided between the first metal layer and the carrier substrate as required. According to some embodiments (as shown in FIG. 4), the conductive film 100 may include at least part of the carrier substrate SUB1. Further, when the conductive film 100 includes at least part of the carrier substrate SUB1, there is no release layer between the carrier substrate SUB1 and the first metal layer.

In this embodiment, the material of the first metal layer M1 may include copper, titanium, nickel, gold, other suitable conductive materials or a combination thereof, but is not limited thereto.

In this embodiment, the first insulating layer IL1 has an opening O1. The opening O1 may expose a portion of the first metal layer M1. The first insulating layer IL1 may have a single-layer structure or a multi-layer structure, and may include, for example, organic materials, inorganic materials, or a combination thereof, but is not limited thereto. The method for forming the opening O1 includes, but is not limited to, a yellow light process, a laser process, mechanical drilling and other suitable processes or a combination thereof, but not limited thereto.

Next, please continue to refer to FIG. 1A, a second metal layer M2 is formed on a part of the first insulating layer IL1, the second metal material is filled in the opening O1, and a second insulating layer IL2 is formed on the second metal layer M2. In this embodiment, the second insulating layer IL2 has an opening O2. The opening O2 may expose a part of the second metal layer M2. In the normal direction of the supporting layer 110 (i.e., the direction Z), the opening O2 and the opening O1 may be disposed in a misaligned position, and the opening O2 may not overlap the opening O1, but is not limited thereto. In this embodiment, the material of the second metal layer M2 and the second metal material may include copper, titanium, nickel, gold, other suitable conductive materials or a combination thereof, but are not limited thereto. The second insulating layer IL2 may have a single-layer structure or a multi-layer structure, and may include, for example, organic materials, inorganic materials, or a combination thereof, but is not limited thereto.

According to some embodiments, the method for forming the first insulating layer IL1 and the second insulating layer IL2 includes a surface treatment step. For example, the surface treatment includes heat treatment, chemical treatment, mechanical treatment and other suitable processes or combinations thereof, but not limited thereto. Through the surface treatment step, the bonding capability between the insulating layers, the stability of the insulating layers may be improved, or the warping may be reduced, but not limited thereto.

According to some embodiments, the method for forming the metal layer includes surface electroplating, electroless plating and other suitable processes or combinations thereof, but is not limited thereto. In the step of forming the metal layer, dry film photoresist, wet film photoresist and other suitable materials or combinations thereof may be used, but not limited thereto.

In some embodiments, the direction Z may also be the stacking direction of the first insulating layer IL1 and the second insulating layer IL2.

In this embodiment, the combination of the first insulating layer IL1 and the second insulating layer IL2 may serve as the supporting layer 110 of this embodiment. Therefore, the supporting layer 110 has been formed on the carrier substrate SUB1 at this stage. The first surface 111 of the supporting layer 110 is the surface of the second insulating layer IL2 facing away from the first metal layer M1, and the second surface 112 of the supporting layer 110 is the surface of the first insulating layer IL1 facing the first metal layer M1. In this embodiment, although the supporting layer 110 may have a two-layer structure, the present disclosure does not limit the number of supporting layers. In some embodiments, the supporting layer 110 may also be a single-layer structure or a multi-layer (i.e., more than two layers) structure.

In this embodiment, the elongation of the second insulating layer IL2 near the first protruding part 120 may be greater than the elongation of the first insulating layer IL1 near the second protruding part 130, so as to provide a buffering or stress releasing effect when a probe head (first protruding part 120) is pressed down by the object under test, wherein, the elongation of the second insulating layer IL2 may be, for example, 50% to 180%, but is not limited thereto. In this embodiment, the Young's modulus of the second insulating layer IL2 near the first protruding part 120 may be smaller than the Young's modulus of the first insulating layer IL1 near the second protruding part 130, so as to provide a buffering or stress releasing effect when the probe head (first protruding part 120) is pressed down by the object under test, but it is not limited thereto. In this embodiment, the materials of the first insulating layer IL1 and the second insulating layer IL2 may be the same or different. The material of the second insulating layer IL2 may be an organic material with a buffering effect, so as to provide a buffering or stress releasing effect when the probe head (first protruding part 120) is pressed down by the object under test. For example, the material of the second insulating layer IL2 may be, for example, polymer, polyimide, photosensitive polyimide (PSPI), silicone rubber, epoxy, build up film, other organic materials with a buffering effect, or a combination of the foregoing, but not limited thereto. The elongation or Young's modulus mentioned in the disclosure may be obtained by a universal testing machine or a corresponding standard test method.

In the embodiment, in the normal direction of the supporting layer 110 (i.e., the direction Z), the first insulating layer IL1 has a height H1, and the second insulating layer IL2 has a height H2, wherein the height H1 is, for example, the height measured along the direction Z of the first insulating layer IL1, and the height H2 is, for example, the height measured along the direction Z of the second insulating layer IL2. In this embodiment, the height H2 may be, for example, greater than the height H1 and less than or equal to 5 times the height H1 (i.e., H1<H2≤5×H1), so as to provide a better buffering or stress releasing effect when the probe head (first protruding part 120) is pressed down by the object under test, but is not limited thereto.

Next, please continue to refer to FIG. 1A, a third metal layer M3 is formed on the second insulating layer IL2, the third metal material is filled into the opening O2, and a planarization process is performed on the third metal layer M3. In this embodiment, the planarization process is, for example, performed by using the grinding tool 200 to perform grinding, so that the surface M31 of the third metal layer M3 away from the second insulating layer IL2 may be flat without unevenness, so as to improve the effect of subsequent electrical testing. In this embodiment, the material of the third metal layer M3 and the third metal material may include copper, titanium, nickel, gold, other suitable conductive materials or combinations thereof, but are not limited thereto.

In this embodiment, the combination of the opening O2, the second metal layer M2 and the opening O1 may be used as the connecting part 140 of this embodiment. Therefore, the connecting part 140 of the circuit layer CL has been formed on the carrier substrate SUB1 at this stage. In this embodiment, although the connecting part 140 may be a combination of the opening O2, the second metal layer M2 and the opening O1, the present disclosure does not limit the structure of the connecting part 140. In some embodiments, the connecting part may also be the opening O1, the second metal layer M2 or the opening O2, as long as the connecting part may be used to connect the first protruding part 120 and the second protruding part 130.

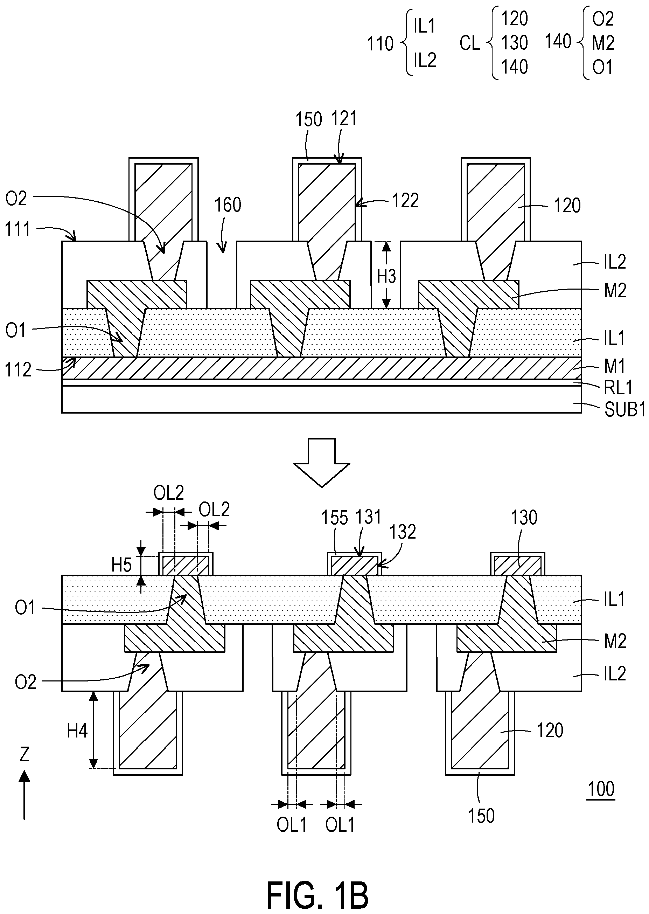

Then, referring to FIG. 1B, a first etching process (such as wet etching) is performed on the third metal layer M3 to form the first protruding part 120 on the first surface 111 of the supporting layer 110, wherein the first protruding part 120 may overlap the opening O2 in the normal direction (i.e., the direction Z) of the supporting layer 110. The first protruding part 120 may be electrically connected to the second metal layer M2 through the opening O2. The shape of the first protruding part 120 may be a rectangle, but is not limited thereto. In some embodiments, the shape of the first protruding part 120 may also be taper, arc or semicircle.

Next, please continue to refer to FIG. 1B, a protective layer 150 is formed on the first protruding part 120. In this embodiment, for example, the protective layer 150 is formed by electroplating, chemical plating, sputtering or other suitable methods. The protective layer 150 may cover the upper surface 121 and the side surface 122 of the first protruding part 120 to reduce the probability of oxidation of the first protruding part 120. The protective layer 150 includes conductive materials. For example, the protective layer 150 may include nickel, gold, silver, copper, other suitable conductive materials or combinations thereof, but not limited thereto.

Next, please continue to refer to FIG. 1B, a second etching process (such as plasma etching) or a drilling process (such as laser drilling) is performed on the second insulating layer IL2 to form a trench 160 of the supporting layer 110, wherein the trench 160 may be disposed between two adjacent openings O2 or between two adjacent first protruding parts 120. The trench 160 may not overlap the opening O2, the second metal layer M2 and the opening O1 in the normal direction of the supporting layer 110 (i.e., the direction Z). The trench 160 may expose a portion of the first insulating layer IL1, but is not limited thereto.

In this embodiment, the trench 160 has a height H3 in the normal direction (i.e., the direction Z) of the supporting layer 110, wherein the height H3 is, for example, the height measured along the direction Z of the trench 160. In some embodiments, the height H3 may be greater than or equal to 1/3 times the height H2 of the second insulating layer IL2 and less than or equal to the height H2 of the second insulating layer IL2 (i.e., 1/3×H2≦H1≦H2), but is not limited thereto.

The conventional conductive film often needs to be replaced frequently due to the aging or wear of the probe head. Since the design of the trench 160 in this embodiment (including the location and height of the trench 160) may reduce the chance of warpage of the conductive film 100, or may provide a buffer space when the probe head (first protruding part 120) collapses when being pressed down by the object under test, it is possible to increase the service life or utilization rate of the probe head and the conductive film 100, thereby achieving the effect of saving cost or improving the convenience of operation.

Next, please continue to refer to FIG. 1B, the release layer RL1 and the carrier substrate SUB1 are removed, they are turned upside down, and a third etching process (such as wet etching) is performed on the first metal layer M1 to form the second protruding part 130 on the second surface 112 of the supporting layer 110, wherein the second protruding part 130 may overlap the opening O1 in the normal direction (i.e., the direction Z) of the supporting layer 110. The second protruding part 130 may be electrically connected to the second metal layer M2 through the opening O1.

In this embodiment, in the normal direction (i.e., the direction Z) of the supporting layer 110, the first protruding part 120 has a height H4, and the second protruding part 130 has a height H5. The height H4 is, for example, the height measured along the direction Z of the first protruding part 120, and the height H5 is, for example, the height measured along the direction Z of the second protruding part 130. In this embodiment, the height H4 of the first protruding part 120 may be greater than the height H5 of the second protruding part 130 (i.e., H5<H4), so as to provide a buffering or stress releasing effect when the probe head (first protruding part 120) is pressed down by the object under test, but it is not limited thereto.

In this embodiment, in the normal direction (i.e., the direction Z) of the supporting layer 110, the first protruding part 120 may overlap the first surface 111 to form a first overlapping region OL1, the second protruding part 130 may overlap the second surface 112 to form a second overlapping region OL2, and the second overlapping region OL2 may be, for example, larger than the first overlapping region OL1, but not limited thereto. According to some embodiments, the second overlapping region OL2 may be, for example, larger than the first overlapping region OL1 (i.e., OL1<OL2), so as to provide a buffering or stress releasing effect when the second protruding part 130 is bonded to the bonding pad 102, but is not limited thereto.

Next, please continue to refer to FIG. 1B, a protective layer 155 is formed on the second protruding part 130. In this embodiment, the protective layer 155 is formed, for example, by electroplating, electroless plating or sputtering. The protective layer 155 may cover the upper surface 131 and the side surface 132 of the second protruding part 130 to reduce the probability of oxidation of the second protruding part 130. The protective layer 155 may be, for example, a nickel-gold plating film, but is not limited thereto. In some embodiments, it may not be necessary to form an additional protective layer on the second protruding part depending on the requirement. At this stage, the conductive film 100 has been fabricated.

Then, please refer to FIG. 1C, the conductive film 100 is electrically connected to the circuit board 101 through the bonding pad 102. In this embodiment, the bonding pad 102 is disposed between the upper surface 131 of the second protruding part 130 and the circuit board 101. The second protruding part 130 of the conductive film 100 may be bonded to the circuit board 101 through the bonding pad 102, wherein the bonding pad 102 may be, for example, a solder ball, but is not limited thereto. At this stage, the test component 10 has been manufactured.

Other embodiments are listed below for illustration. It must be noted here that the following embodiments use the component numbers and part of the content of the previous embodiments, wherein the same numbers are used to denote the same or similar components, and descriptions of the same technical content are omitted. For the description of omitted parts, reference may be made to the foregoing embodiments, and the following embodiments will not be repeated.

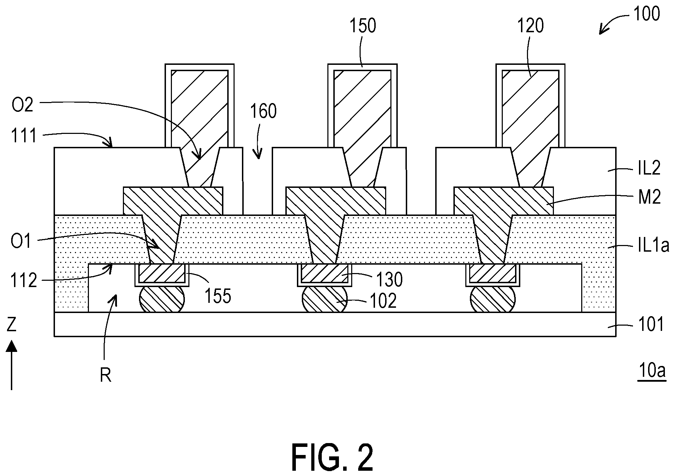

FIG. 2 to FIG. 7 are schematic cross-sectional views of test components according to various embodiments of the present disclosure.

First, please refer to FIG. 2 and FIG. 1C at the same time. The test component 10a of this embodiment is similar to the test component 10 of FIG. 1C, and the only difference between the two is that, in the test component 10a of this embodiment, the first insulating layer IL1a has a groove R, and the first insulating layer IL1a may contact the circuit board 101. Specifically, please refer to FIG. 2, in this embodiment, the bottom surface of the groove R is the second surface 112 of the supporting layer 110, and the second protruding part 130, the protective layer 155 and the bonding pad 102 may be disposed in the groove R.

Then, please refer to FIG. 3 and FIG. 1C at the same time. The test component 10b of this embodiment is similar to the test component 10 of FIG. 1C, and the only difference between the two is that: in the test component 10b of this embodiment, the supporting layer 110b is a single-layered first insulating layer or a second insulating layer, the connecting part 140b is the opening O2, and no additional protective layer may be provided on the second protruding part 130. In addition, in this embodiment, the angle θ between the side wall O2a of the opening O2 (or the connecting part 140b) and the second surface 112 of the supporting layer 110b may be an acute angle, and the angle θ may be, for example, 50 degrees to 85 degrees, but is not limited thereto. Through the design of the above included angle, the bonding force between the metal layer and the insulating layer may be improved or the buffering capacity may be provided, so as to avoid aging of the test component or the conductive film due to repeated use, but not limited thereto.

Then, please refer to FIG. 4 and FIG. 3 at the same time. The test component 10c of this embodiment is similar to the test component 10b of FIG. 3, and the only difference between the two lies in that: the test component 10c of this embodiment further includes a buffer layer 170, a carrier substrate SUB1 and a driving element 103.

Specifically, the buffer layer 170 is disposed on the first surface 111 of the supporting layer 110b, and the buffer layer 170 may cover part of the side surface 122 of the first protruding part 120. The buffer layer 170 may be used for buffering or releasing stress. The material of the buffer layer 170 may be an organic material with a buffering effect, such as polymer, polyimide, photosensitive polyimide, silicone rubber, epoxy, other organic materials with a buffering effect, or a combination thereof, but is not limited thereto.

The carrier substrate SUB1 has an upper surface SUB1a, a side surface SUB1b, and a lower surface SUB1c. The upper surface SUB1a and the lower surface SUB1c are opposite to each other, and the side surface SUB1b may connect the upper surface SUB1a and the lower surface SUB1c.

The second protruding part 130c and the supporting layer 110c are disposed on the upper surface SUB1a of the carrier substrate SUB1. The second protruding part 130c may be embedded in the supporting layer 110c and not protrude from the second surface 112 of the supporting layer 110c. In some embodiments, the upper surface 131 of the second protruding part 130c may be substantially aligned with the second surface 112 of the supporting layer 110c, but is not limited thereto.

The circuit board 101 is disposed on the lower surface SUB1c of the carrier substrate SUB1, and the driving element 103 is disposed on the lower surface SUB1c and the side surface SUB1b of the carrier substrate SUB1. The circuit board 101 may be electrically connected to the second protruding part 130c through the driving element 103. In some embodiments, the driving element 103 may be connected to the circuit board 101 and contact the side surface of the second protruding part 130c, but is not limited thereto. In some embodiments, the driving element 103 may be a chip-on-film (COF), but not limited thereto.

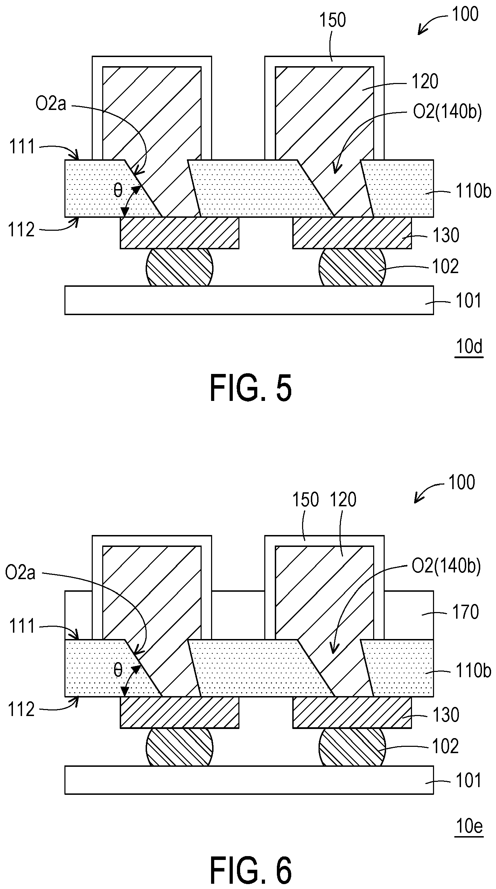

Then, please refer to FIG. 5 and FIG. 3 at the same time. The test component 10d of this embodiment is similar to the test component 10b of FIG. 3, but the only difference between the two is that in the test component 10d of this embodiment, the angle θ between the side wall O2a of the opening O2 (or the connecting part 140b) and the second surface 112b of the supporting layer 110b is 60 degrees to 75 degrees, so as to provide the effect of buffering or releasing stress.

Then, please refer to FIG. 6 and FIG. 5 at the same time. The test component 10e of the present embodiment is similar to the test component 10d of FIG. 5, and the only difference between the two is that the test component 10e of this embodiment also includes a buffer layer 170 to provide a buffering or stress releasing effect. Specifically, the buffer layer 170 is disposed on the first surface 111 of the supporting layer 110b, and the buffer layer 170 may cover part of the side surface 122 of the first protruding part 120. The material of the buffer layer 170 may be an organic material with a buffering effect, such as polymer, polyimide, photosensitive polyimide, silicone rubber, other organic materials with a buffering effect, or a combination thereof, but is not limited thereto.

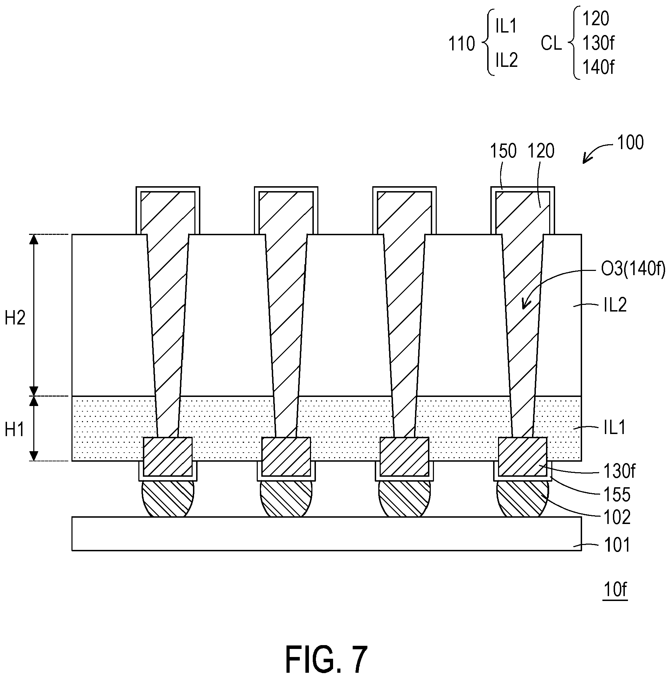

Then, please refer to FIG. 7 and FIG. 1C at the same time. The test component 10f of this embodiment is similar to the test component 10 of FIG. 1C, and the only difference between the two is: in the test component 10f of this embodiment, the connecting part 140f is an opening O3 that penetrates both the second insulating layer IL2 and the first insulating layer IL1, and the second protruding part 130f may be partially buried in the first insulating layer IL1. Since the opening O3 has a slender structure, the design of the slender opening O3 may also provide a buffering or stress releasing effect when the object under test presses down on the probe head (the first protruding part 120).

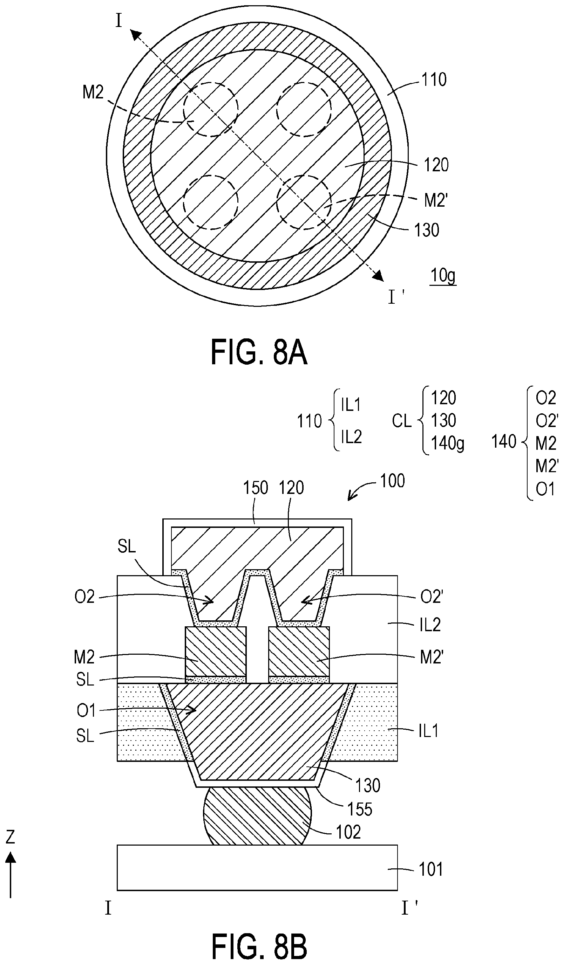

FIG. 8A is a schematic top view of a test component according to another embodiment of the disclosure. FIG. 8B is a schematic cross-sectional view of the test component of FIG. 8A along the section line I-I'. For clarity and ease of illustration, FIG. 8A omits some elements in the test component 10g. Please refer to FIG. 8A, FIG. 8B and FIG. 1C at the same time. The test component 10g of this embodiment is similar to the test component 10 of FIG. 1C, but the only difference between the two is that in the test component 10g of this embodiment, the second insulating layer IL2 also has an opening O2', and the connecting part 140g further includes a second metal layer M2' and an opening O2' filled with a third metal material.

Specifically, please refer to FIG. 8A and FIG. 8B at the same time. The second metal layer M2 and the second metal layer M2' are disposed adjacent to the opening O1, and the second metal layer M2 and the second metal layer M2' may overlap the same opening O1 in the normal direction (that is, the direction Z) of the supporting layer 110. The opening O2' may be adjacent to the opening O2, and the opening O2' may overlap and correspond to the second metal layer M2'.

In this embodiment, since the opening O2 and the opening O2' (or the second metal layer M2 and the second metal layer M2') may correspond to the same first protruding part 120, when the object under test presses the probe head (the first protruding part 120), the design of two openings (that is, the opening O2 and the opening O2') or two metal layers (that is, the second metal layer M2 and the second metal layer M2') may be used to provide a buffering or stress releasing effect.

In addition, in this embodiment, there is a seed layer SL at the junction of the first protruding part 120 and the second insulating layer IL2, the junction of the opening O2 and the second insulating layer IL2, the junction of the opening O2' and the second insulating layer IL2, the junction of the second metal layer M2 and the opening O1, the junction of the second metal layer M2' and the opening O1, and the junction of the opening O1 and the first insulating layer IL1, but not limited thereto. In some embodiments, it may not be necessary to provide an additional seed layer depending on the requirement.

In addition, in the top view of the test component 10g in FIG. 8A, the shapes of the second metal layer M2 and the second metal layer M2' may be circular or square, but not limited thereto.

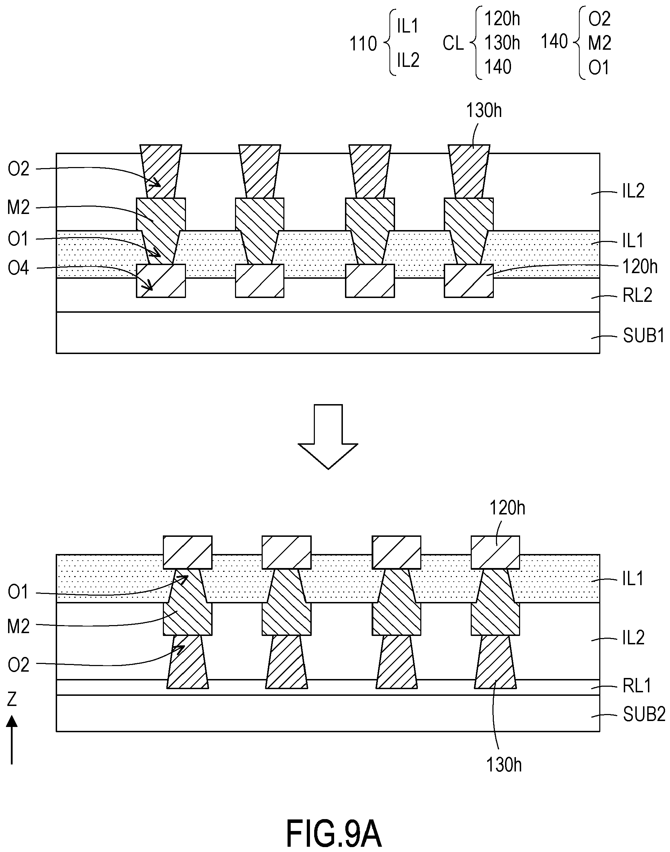

FIG. 9A to FIG. 9B are schematic cross-sectional views of a manufacturing method of a test component according to another embodiment of the present disclosure. The embodiments shown in FIG. 9A to FIG. 9B are similar to the embodiments shown in FIG. 1A to FIG. 1C. Therefore, the same or similar components may be made using the same materials or methods. The same and similar descriptions of the two embodiments will not be repeated below, and the focus mainly lies in the differences between the two embodiments.

In this embodiment, the manufacturing method of the test component 10h may include the following steps:

Specifically, referring to FIG. 9A, a carrier substrate SUB1 is provided, a sacrificial layer RL2 is formed on the carrier substrate SUB1, a first protruding part 120h is formed on the sacrificial layer RL2 and in the opening O4 of the sacrificial layer RL2, a first insulating layer IL1 is formed on the first protruding part 120h, a second metal material is filled in the opening O1 of the first insulating layer IL1, a second metal layer M2 is formed on part of the first insulating layer IL1, a second insulating layer IL2 is formed on the second metal layer M2 and the first insulating layer IL1, a third metal material is filled into the opening O2 of the second insulating layer IL2, and a second protruding part 130h is formed on the second insulating layer IL2. The sacrificial layer RL2 may be removed together with the carrier substrate SUB1 in subsequent steps. The material of the sacrificial layer RL2 may include easily removable materials such as silicon nitride or silicon oxide, but is not limited thereto. The opening O2 may overlap the opening O1 in a normal direction (i.e., direction Z) of the supporting layer 110.

Next, please continue to refer to FIG. 9A, the sacrificial layer RL2 and the carrier substrate SUB1 are removed, they are turned upside down, and placed on another carrier substrate SUB2 and the release layer RL1. The first protruding part 120h may be partially embedded in the second insulating layer IL2, and the second protruding part 130h may be partially embedded in the release layer RL1.

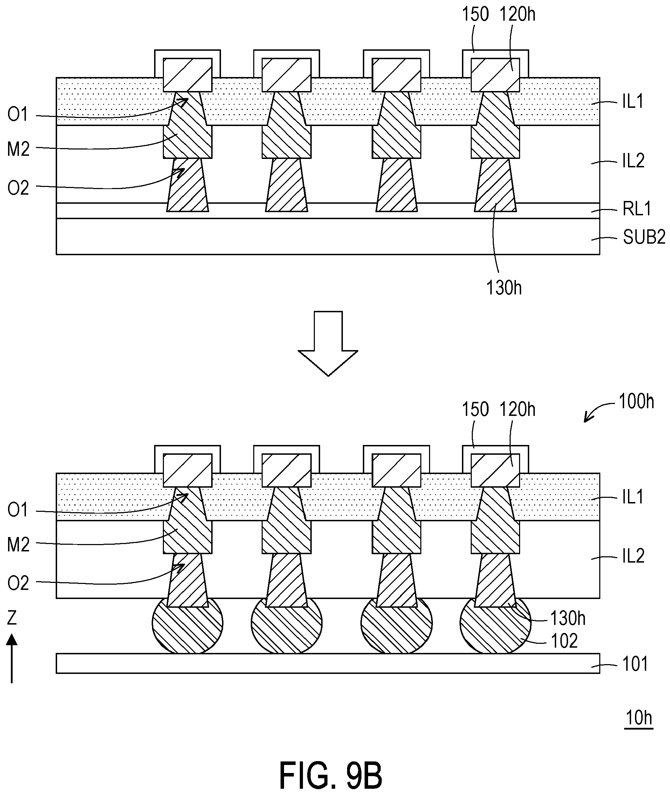

Then, referring to FIG. 9B, a protective layer 150 is formed on the first protruding part 120h. At this stage, the conductive film 100h has been manufactured.

Next, please continue to refer to FIG. 9B, the release layer RL1 and another carrier substrate SUB2 are removed, and the conductive film 100h is electrically connected to the circuit board 101 through the bonding pad 102. The bonding pad 102 may be disposed between the upper surface 131 of the second protruding part 130 and the circuit board 101, and the bonding pad 102 may also cover the side surface 132 of the second protruding part 130, thereby increasing the contact area between the bonding pad 102 and the second protruding part 130.

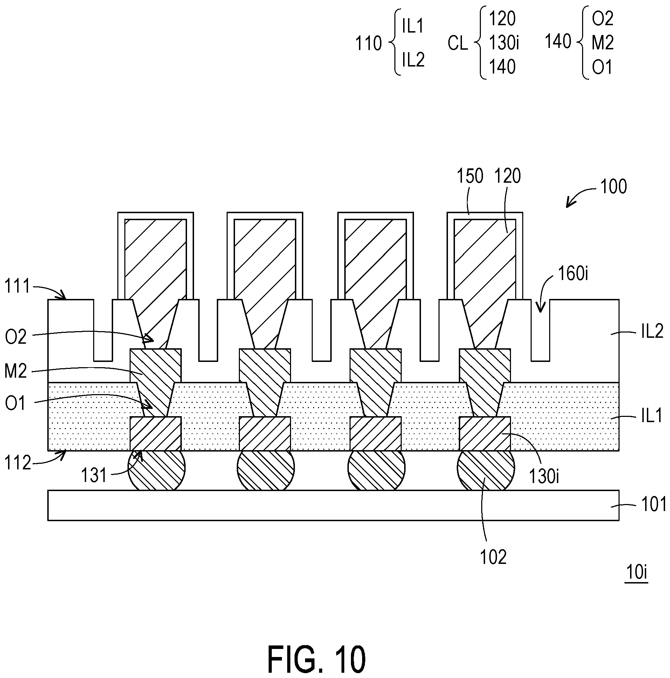

FIG. 10 to FIG. 12 are schematic cross-sectional views of test components according to various embodiments of the present disclosure.

First, please refer to FIG. 10 and FIG. 1C at the same time. The test component 10i of this embodiment is similar to the test component 10 of FIG. 1C, and the only difference between the two is: in the test assembly 10i of this embodiment, the first insulating layer IL1 is not exposed by the trench 160i, and the opening O2 may overlap the opening O1 in the normal direction (i.e., the direction Z) of the supporting layer 110. The second protruding part 130i may be embedded in the first insulating layer IL1 and not protrude from the second surface 112 of the supporting layer 110. In some embodiments, the upper surface 131 of the second protruding part 130i may be substantially aligned with the second surface 112 of the supporting layer 110, but is not limited thereto.

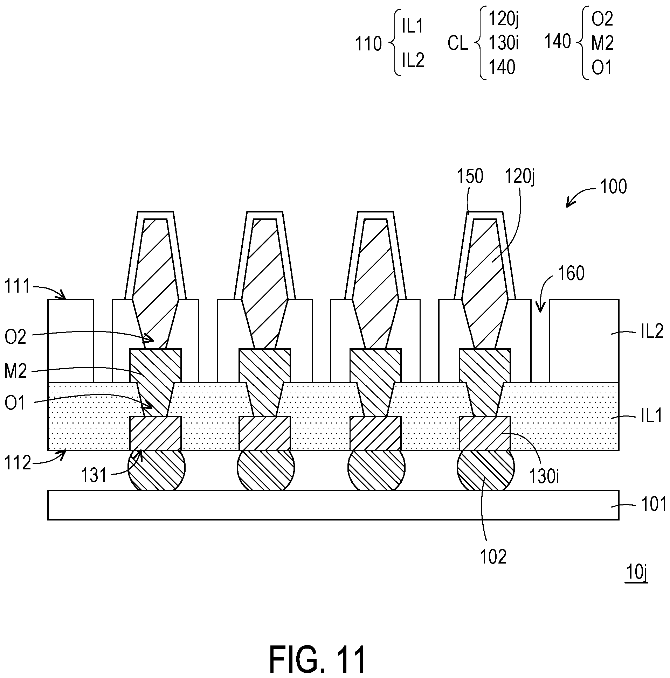

Then, please refer to FIG. 11 and FIG. 10 at the same time. The test component 10j of this embodiment is similar to the test component 10i of FIG. 10, and the only difference between the two is that, in the test component 10j of this embodiment, the shape of the first protruding part 120j is tapered. Therefore, when there is an oxide layer on the surface of the object under test, the tapered first protruding part 120j may be used to pierce the oxide layer, so that the first protruding part 120j may contact the object under test for electrical detection. In addition, in this embodiment, the trench 160 may expose the first insulating layer IL1.

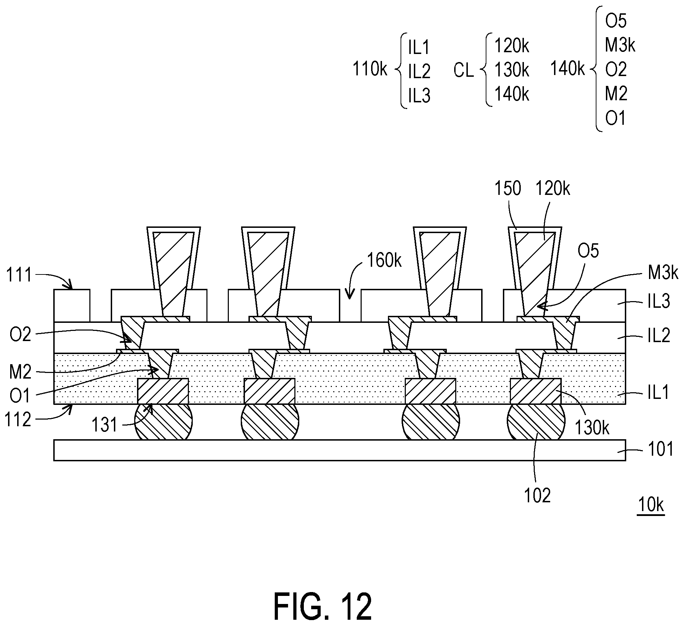

Then, please refer to FIG. 12 and FIG. 1C at the same time. The test component 10k of this embodiment is similar to the test component 10 of FIG. 1C, and the only difference between the two is that: in the test component 10k of this embodiment, the supporting layer 110k further includes a third insulating layer IL3, and the connecting part 140k further includes a third metal layer M3k and an opening O5 filled with a fourth metal material.

Specifically, referring to FIG. 12, the third metal layer M3k is disposed on part of the second insulating layer IL2, the third insulating layer IL3 is disposed on the third metal layer M3k and the second insulating layer IL2, and the third insulating layer IL3 has an opening O5 and a trench 160k. The opening O5 may expose a portion of the third metal layer M3k. The trench 160k is disposed adjacent to the opening O5, and the trench 160k may expose part of the second insulating layer IL2. The first protruding part 120k is disposed on the third insulating layer IL3, and the first protruding part 120k may be electrically connected to the third metal layer M3k through the opening O5 filled with the fourth metal material. The shape of the first protruding part 120k is an inverted taper. In this embodiment, the fourth metal material may include copper, titanium, nickel, gold, other suitable conductive materials, or a combination thereof, but is not limited thereto.

The second protruding part 130k may be embedded in the first insulating layer IL1 and not protrude from the second surface 112 of the supporting layer 110k. In some embodiments, the upper surface 131 of the second protruding part 130 may be substantially aligned with the second surface 112 of the supporting layer 110k, but is not limited thereto.

To sum up, in the conductive film and the test component of the disclosed embodiments, since the height of the first protruding part may be greater than that of the second protrusion, it is possible to provide a buffering or stress releasing effect when the first protruding part is pressed down by the object under test. Since the design of the trench in this embodiment (including the position and height of the trench) may reduce the probability of warping of the conductive film, or provide a buffer space when the probe head (first protruding part) collapses due to the pressure of the object under test, it is possible to increase the service life or utilization rate of the probe head and the conductive film 100, thereby achieving the effect of saving costs or improving the convenience of operation. Since the elongation of the second insulating layer may be greater than that of the first insulating layer, the Young's modulus of the second insulating layer may be smaller than the Young's modulus of the first insulating layer, and the material of the second insulating layer may be an organic material with a buffering effect, or the height of the second insulating layer may be greater than the height of the first insulating layer and less than or equal to 5 times the height of the first insulating layer, it is possible to provide a buffering or stress releasing effect when the first protruding part is pressed down by the object under test. Since the angle between the side wall of the connecting part and the second surface of the supporting layer is 60° to 75°, it is possible to provide a buffering or stress releasing effect when the first protruding part is pressed down by the object under test.

## Claims

1. A conductive film (100, 100h), comprising:
a supporting layer (110, 110b, 110c, 110k), having a first surface (111) and a second surface (112) opposite to the first surface (111);
a circuit layer (CL), wherein the supporting layer (110, 110b, 110c, 110k) supports the circuit layer (CL), and the circuit layer (CL) comprises:
a first protruding part (120, 120h, 120j, 120k), disposed on the first surface (111);
a second protruding part (130, 130c, 130f, 130h, 130i, 130k), disposed on the second surface (112); and
a connecting part (140, 140b, 140f, 140g, 140k), disposed between the first protruding part (120, 120h, 120j, 120k) and the second protruding part (130, 130c, 130f, 130h, 130i, 130k), wherein the first protruding part (120, 120h, 120j, 120k) is connected to the second protruding part (130, 130c, 130f, 130h, 130i, 130k) through the connecting part (140, 140b, 140f, 140g, 140k); and
a protective layer (150), covering the first protruding part (120, 120h, 120j, 120k).

2. The conductive film (100, 100h) according to claim 1, wherein in a normal direction of the supporting layer (110, 110b, 110c, 110k), a height (H4) of the first protruding part (120, 120h, 120j, 120k) is greater than a height (H5) of the second protruding part (130, 130c, 130f, 130h, 130i, 130k).

3. The conductive film (100, 100h) according to claim 1, wherein the first protruding part (120) overlaps the first surface (111) to form a first overlapping region (OL1), the second protruding part (130) overlaps the second surface (112) to form a second overlapping region (OL2), and the second overlapping region (OL2) is larger than the first overlapping region (OL1).

4. The conductive film (100) according to claim 1, wherein the supporting layer (110, 110k) has a trench (160, 160k).

5. The conductive film (100) according to claim 4, wherein the trench (160, 160k) is disposed between two of the adjacent first protruding parts (120, 120j, 120k).

6. The conductive film (100, 100h) according to claim 1, wherein the supporting layer (110, 110b, 110c, 110k) is a single layer or multiple layers.

7. The conductive film (100, 100h) according to claim 1, wherein the supporting layer (110, 110k) comprises a first insulating layer (IL1, IL1a) adjacent to the second protruding part (130, 130f, 130h, 130i, 130k) and a second insulating layer (IL2) adjacent to the first protruding part (120, 120h, 120j, 120k),
wherein an elongation of the second insulating layer (IL2) is greater than that of the first insulating layer (II,1, IL1a).

8. The conductive film (100, 100h) according to claim 7, wherein the first insulating layer (IL1, IL1a) has a first height (H1), the second insulating layer (IL2) has a second height (H2), and the second height (H2) is greater than the first height (H1) and less than or equal to 5 times the first height (H1).

9. The conductive film (100) according to claim 8, wherein the connecting part (140f) is an opening (O3) penetrating through the first insulating layer (IL1) and the second insulating layer (IL2) simultaneously.

10. The conductive film (100) according to claim 7, wherein the second insulating layer (IL2) has a second height (H2), the second insulating layer (IL2) has a trench (160), the trench (160) has a third height (H3), and the third height (H3) is greater than or equal to 1/3 times the second height (H2) and less than or equal to the second height (H2).

11. A test component (10, 10a, 10b, 10c, 10d, 10e, 10f, 10g, 10h, 10i, 10j, 10k), comprising:
a circuit board (101);
a bonding pad (102); and
a conductive film (100, 100h), electrically connected to the circuit board (101) through the bonding pad (102), wherein the conductive film (100, 100h) comprises:
a supporting layer (110, 110b, 110c, 110k), having a first surface (111) and a second surface (112) opposite to the first surface (111);
a circuit layer (CL), wherein the supporting layer (110, 110b, 110c, 110k) supports the circuit layer (CL), and the circuit layer (CL) comprises:
a first protruding part (120, 120h, 120j, 120k), disposed on the first surface (111);
a second protruding part (130, 130c, 130f, 130h, 130i, 130k), disposed on the second surface (112); and
a connecting part (140, 140b, 140f, 140g, 140k), disposed between the first protruding part (120, 120h, 120j, 120k) and the second protruding part (130, 130c, 130f, 130h, 130i, 130k), wherein the first protruding part (120, 120h, 120j, 120k) is connected to the second protruding part (130, 130c, 130f, 130h, 130i, 130k) through the connecting part (140, 140b, 140f, 140g, 140k); and
a protective layer (150), covering the first protruding part (120, 120h, 120j, 120k).

12. The test component (10, 10a, 10b, 10c, 10d, 10e, 10f, 10g, 10h, 10i, 10j, 10k) according to claim 11, wherein in a normal direction of the supporting layer (110, 110b, 110c, 110k), a height (H4) of the first protruding part (120, 120h, 120j, 120k) is greater than a height (H5) of the second protruding part (130, 130c, 130f, 130h, 130i, 130k).

13. The test component (10, 10a, 10b, 10d, 10e) according to claim 11, wherein the first protruding part (120) overlaps the first surface (111) to form a first overlapping region (OL1), the second protruding part (130) overlaps the second surface (112) to form a second overlapping region (OL2), and the second overlapping region (OL2) is larger than the first overlapping region (OL1).

14. The test component (10, 10a, 10h, 10i, 10j, 10k) according to claim 11, wherein the supporting layer (110, 110k) has a trench (160, 160k).

15. The test component (10, 10a, 10b, 10c, 10d, 10e, 10f, 10g, 10h, 10i, 10j, 10k) according to claim 11, wherein the supporting layer (110, 110b, 110c, 110k) is a single layer or multiple layers.
